# EUROPÄISCHE PATENTSCHRIFT

(11) **EP 3 894 259 B1**
(45) Veröffentlichungstag und Bekanntmachung des Hinweises auf die Patenterteilung: **12.08.2026**
(21) Anmeldenummer: 19816566.4
(22) Anmeldetag: 29.11.2019
(51) Int. Cl.: H03K 17/96, H03K 17/965, H01H 9/18, B60K 35/10, B60K 35/22, B60K 35/60

(54) **BEDIENFELDANORDNUNG FÜR EIN FAHRZEUG**
CONTROL PANEL ARRANGEMENT FOR A VEHICLE
AGENCEMENT D'UN TABLEAU DE COMMANDE POUR UN VÉHICULE

(30) Priorität: 13.12.2018 DE 102018221707
(43) Veröffentlichungstag der Anmeldung: 20.10.2021
(73) Patentinhaber: VOLKSWAGEN AKTIENGESELLSCHAFT, 38440 Wolfsburg (DE)
(72) Erfinder: HUWER, Wojciech, 38110 Braunschweig (DE); ROSILIUS, Marcel, 38440 Wolfsburg (DE)
(86) Internationale Anmeldenummer: PCT/EP2019/083059
(87) Internationale Veröffentlichungsnummer: WO 2020/120171

(56) Entgegenhaltungen:
- WO-A2-2016/177878
- DE-A1- 102015 008 573
- US-A1- 2009 237 364
- US-A1- 2015 344 059

## Beschreibung

Die Erfindung betrifft eine Bedienfeldanordnung für ein Fahrzeug gemäß dem Oberbegriff des Patentanspruchs 1 und ein Fahrzeug gemäß dem Oberbegriff des Patentanspruchs 4.

Im Fahrzeugbereich, beispielsweise bei Kraftfahrzeugen, sind unterschiedliche Lösungen bekannt, um Bedienelemente zu realisieren. Diese umfassen mechanisch betätigbare Bedienelemente, wie beispielsweise Schalter, Taster, Hebel und dergleichen sowie elektronische Bedienelemente, wie beispielsweise berührungssensitive Bedienelemente. Letztere werden durch Berührung oder Annäherung eines Bedieners bedient. Solche berührungssensitiven Bedienelemente können auch mit Anzeigefunktionen ausgestattet sein, beispielsweise bei Touchdisplays. In der Regel stellen berührungssensitive Bedienfelder dabei mehrere Bedienelemente für unterschiedliche Funktionen bereit.

Die WO 2016 / 177 878 A2 offenbart eine Bedienvorrichtung für ein Fahrzeug, bei der ein mechanisches Bedienelement, wie ein Drehknopf oder Gangwahlhebel, in einer Aussparung eines großflächigen Touchscreens angeordnet ist. Der Touchscreen erstreckt sich dabei ringförmig um das mechanische Element herum, um eine geschlossene, leicht zu reinigende Oberfläche ohne Spalten zu schaffen und so das Eindringen von Schmutz oder Flüssigkeiten zu verhindern.

Die DE 10 2015 008 573 A1 beschreibt eine Bedienvorrichtung, die ein berührungsempfindliches Betätigungselement mit haptischem Feedback kombiniert. Das gesamte Element ist mechanisch beweglich und wird in einer Ruhelage durch ein Zentrierelement fixiert. Bei einer Betätigung durch den Nutzer wird das Element zunächst aus dieser Fixierung gelöst und leicht verlagert, woraufhin ein Aktor eine spürbare Rückmeldung, wie eine Vibration, erzeugt.

Die US 2009 / 0 237 364 A1 offenbart ein Touchscreen-Gerät mit einem dynamisch erzeugbaren, physischen Tastenfeld. Unter einem flexiblen Display ist eine Anordnung von beweglichen Stiften platziert, die von einem elektromechanischen System je nach Bedarf ausgefahren werden können. Diese Stifte drücken gegen die flexible Oberfläche und erzeugen so spürbare, erhabene Tasten, die dem Nutzer ein taktiles Feedback ähnlich einer echten Tastatur geben.

Bei berührungssensitiven Bedienfeldern kann es, insbesondere während der Fahrt, zu einer ungewollten Bedienung eines Bedienelements kommen. Gründe hierfür sind zum einen Erschütterungen und zum anderen die oft räumliche Nähe der Bedienelemente. Möchte der Bediener beispielsweise die Hand bei der Bedienung ablegen, kann so ungewollt ein Bedienelement betätigt werden. Dies ist insbesondere bei sicherheitsrelevanten Bedienelementen, wie beispielsweise einem Warnblinklicht, problematisch. Dennoch ist es erstrebenswert, die Flexibilität und den Komfort durch Nutzung von berührungssensitiven Bedienfeldern zu steigern.

Der Erfindung liegt nun die Aufgabe zugrunde, eine technische Lösung bereitzustellen, mit der eine ungewollte Bedienung vermieden wird.

Die Aufgabe wird durch die Gegenstände der unabhängigen Patentansprüche 1 und 10 gelöst. Weitere bevorzugte Ausgestaltungen der Erfindung ergeben sich aus den übrigen, in den Unteransprüchen genannten Merkmalen

Ein erster Aspekt der Erfindung betrifft eine Bedienfeldanordnung für ein Fahrzeug, umfassend:
- einen berührungssensitiven Bedienbereich; und
- einen mechanisch schaltbaren Bedienbereich.

Erfindungsgemäß ist vorgesehen, dass der mechanisch schaltbare Bedienbereich in den berührungssensitiven Bedienbereich integriert ist.

Dadurch, dass bei mechanisch schaltbaren Bedienbereichen stets eine Kraftschwelle oder auch ein bestimmter Schaltweg überschritten werden muss, um eine Bedienung auszulösen, werden die eingangs beschriebenen Probleme vorteilhaft gelöst. Dabei kann das von dem mechanisch schaltbaren Bedienbereich gebildete Bedienelement vorteilhaft weiterhin in der Bedienoberfläche integriert sein. Komforteinbußen werden dadurch vermieden.

Erfindungsgemäß ist vorgesehen, dass der mechanisch schaltbare Bedienbereich in den berührungssensitiven Bedienbereich eingefasst ist und eine Bedienoberfläche der Bedienfeldanordnung abschnittsweise durch den mechanisch schaltbaren Bedienbereich und abschnittsweise durch den berührungssensitiven Bedienbereich gebildet wird.

Der mechanisch schaltbare Bedienbereich fügt sich so vorteilhaft in den berührungssensitiven Bedienbereich ein und die Bedienfeldanordnung insgesamt kann als funktionale Einheit oder Modul konzipiert sein.

In bevorzugter Ausgestaltung der Bedienfeldanordnung der Erfindung ist vorgesehen, dass die Bedienoberfläche, die durch den mechanisch schaltbaren Bedienbereich gebildet wird von der Bedienoberfläche, die durch den berührungssensitiven Bedienbereich gebildet wird, durch eine Fuge getrennt ist.

Dadurch erfolgt eine sichere Trennung des beweglichen mechanisch schaltbaren Bedienbereichs von dem in der Regel mechanisch statischen berührungssensitiven Bedienbereich.

Erfindungsgemäß ist vorgesehen, dass der mechanisch schaltbare Bedienbereich zusätzlich eine aktive Bedienoberfläche umfasst.

Die aktive Bedienoberfläche kann anzeigende oder auch berührungssensitive Funktionalitäten umfassen. Erfindungsgemäß erfolgt eine Sperrung der Bedienfunktion der aktiven Bedienoberfläche, bis zusätzlich ein definiertes mechanisches Signal erzeugt wird. Somit dient die mechanische Bedienung vorteilhaft als Sicherheitsmechanismus, wobei die eigentliche Funktion des Bedienelements in die Funktionalität des berührungssensitiven Bedienbereichs eingebettet sein kann, was die Steuerung vereinfacht. Auch ist es mit der aktiven Bedienoberfläche vorteilhaft möglich, unterschiedliche oder auch wechselnde Bedienelemente anzuzeigen und die zugehörige Funktionalität der unterschiedlichen Bedienelemente bereitzustellen, stets abgesichert durch die erforderliche mechanische Bedienung.

In einer nicht zur Erfindung gehörenden Ausgestaltung der Bedienfeldanordnung ist vorgesehen, dass der mechanisch schaltbare Bedienbereich hinter dem berührungssensitiven Bedienbereich angeordnet ist und der berührungssensitive Bedienbereich zumindest im Bereich des mechanisch schaltbaren Bedienbereichs in Richtung des mechanisch schaltbare Bedienbereichs verlagerbar ist.

Mit anderen Worten wird die Bedienoberfläche hierbei zwar durch den berührungssensitiven Bedienbereich gebildet, wobei über dessen Verlagerung aber der mechanisch schaltbare Bedienbereich ebenfalls betätigt werden muss, um die Funktionalität des Bedienelements auszulösen. Vorteilhafterweise kann sich der berührungssensitive Bedienbereich so auch über die gesamte Bedienoberfläche der Bedienfeldanordnung erstrecken und flexibel genutzt werden, wobei der mechanisch schaltbare Bedienbereich verborgen bleibt und im Hintergrund die Sicherungsfunktionalität bereitstellt.

In einer nicht zur Erfindung gehörenden Ausgestaltung der Bedienfeldanordnung ist vorgesehen, dass der berührungssensitive Bedienbereich zumindest im Bereich des mechanisch schaltbaren Bedienbereichs flexible Eigenschaften aufweist.

Derartige flexible berührungssensitive Bedienbereiche sind dem Fachmann bekannt und bieten in Verbindung mit dem dahinterliegenden mechanisch schaltbaren Bedienbereich den spezifischen Vorteil, dass dessen Sicherungsfunktion mit sehr geringem Aufwand eingebunden werden kann, nämlich durch die beschriebene Anordnung und eine steuerungstechnische Verschaltung.

In einer nicht zur Erfindung gehörenden Ausgestaltung der Bedienfeldanordnung ist vorgesehen, dass der berührungssensitive Bedienbereich zumindest im Bereich des mechanisch schaltbaren Bedienbereichs über eine Mechanik verlagerbar ist.

Hierfür kann auch ein unflexibler berührungssensitiver Bedienbereich verwendet werden. Die Mechanik kann beispielsweise nach Art eines Tasters funktionieren und beispielsweise eine Kinematik mit einer Rückstellfeder umfassen. Der berührungssensitive Bedienbereich kann als Ganzes verlagert werden, so beispielsweise auch die gesamte Bedienoberfläche der Bedienfeldanordnung oder aber der berührungssensitive Bedienbereich kann einen abgegrenzten verlagerbaren Bereich der Bedienoberfläche der Bedienfeldanordnung bilden.

In weiterhin bevorzugter Ausgestaltung der Bedienfeldanordnung der Erfindung ist vorgesehen, dass der mechanisch schaltbare Bedienbereich ein fahrzeugsicherheitsrelevantes Bedienelement bildet.

Hierbei kommen die Vorteile der Bedienfeldanordnung der Erfindung besonders zur Geltung.

Solche fahrzeugsicherheitsrelevante Bedienelemente können rein beispielhaft Warnblinkbedienelemente oder auch Bedienelemente für Nebelschlussleuchten oder Fernlichter umfassen. Ein Warnblinkbedienelement bietet sich hier besonders an, da ein solches meist im Bereich einer Mittelkonsole eines Fahrzeugs angeordnet ist, in der sich diverse weitere Bedienelemente konzentrieren.

In weiterhin bevorzugter Ausgestaltung der Bedienfeldanordnung der Erfindung ist vorgesehen, dass die Bedienfeldanordnung mehrere mechanisch schaltbare Bedienbereiche umfasst.

Mit Vorteil ist die Bedienfeldanordnung der Erfindung so gut skalierbar und auf unterschiedliche Bedürfnisse anpassbar.

Ein weiterer Aspekt der Erfindung betrifft ein Fahrzeug, umfassend eine erfindungsgemäße Bedienfeldanordnung gemäß der vorhergehenden Beschreibung.

Die verschiedenen in dieser Anmeldung genannten Ausführungsformen der Erfindung sind, sofern im Einzelfall nicht anders ausgeführt, mit Vorteil miteinander kombinierbar.

Die Erfindung wird nachfolgend in Ausführungsbeispielen anhand der zugehörigen Zeichnungen erläutert. Es zeigen:
- Figur 1: eine erfindungsgemäße Bedienfeldanordnung in einer bevorzugten Ausführungsform; und
- Figur 2: ein erfindungsgemäßes Fahrzeug in einer bevorzugten Ausführungsform.

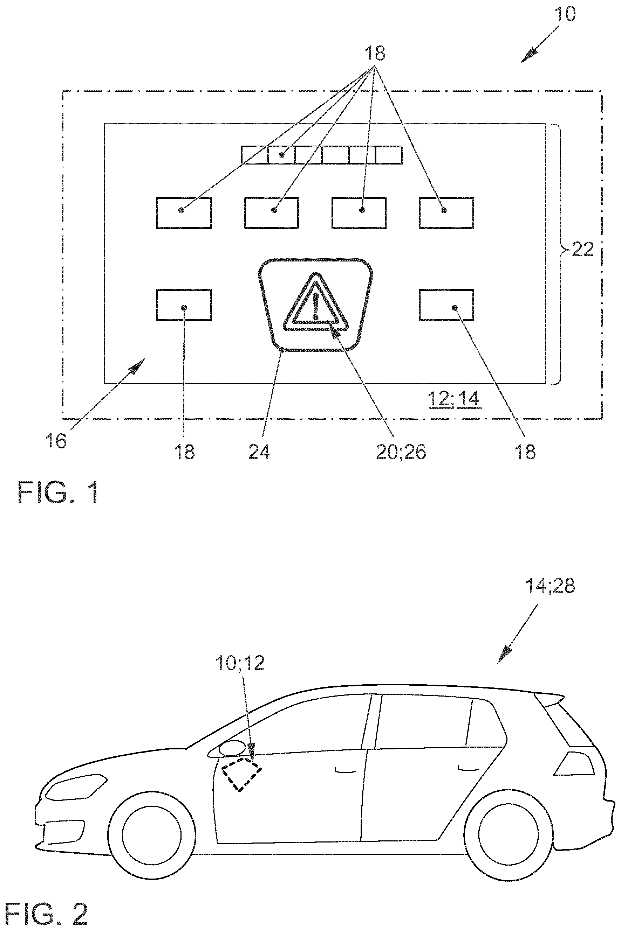

Figur 1 zeigt eine erfindungsgemäße Bedienfeldanordnung 10 in einer bevorzugten Ausführungsform.

Diese ist wie in Figur 2 näher beschrieben in einer Mittelkonsole 12 eines erfindungsgemäßen Fahrzeugs 14 angeordnet.

Die Bedienfeldanordnung 10 umfasst einen berührungssensitiven Bedienbereich 16. In dem berührungssensitiven Bedienbereich 16 sind unterschiedliche Bedienelemente 18 angedeutet, die durch Berührung bedienbar sind und Bedienleisten und Bedienfelder umfassen, mit denen unterschiedliche Fahrzeugfunktionen ansteuerbar sind.

Ferner umfasst die Bedienfeldanordnung 10 einen mechanisch schaltbaren Bedienbereich 20. Dieser ist in etwa mittig in der Bedienfeldanordnung 10 vorgesehen und dabei in den umgebenden berührungssensitiven Bedienbereich 16 integriert beziehungsweise eingefasst.

Mit anderen Worten wird eine Bedienoberfläche 22 der Bedienfeldanordnung 10 somit abschnittsweise durch den mechanisch schaltbaren Bedienbereich 20 und abschnittsweise durch den berührungssensitiven Bedienbereich 16 gebildet.

Da der mechanisch schaltbare Bedienbereich 20 verlagerbar ist, ist er von dem berührungssensitiven Bedienbereich 16 durch eine Fuge 24 getrennt, die den mechanisch schaltbaren Bedienbereich 20 in diesem Beispiel umschließt.

Der mechanisch schaltbare Bedienbereich 20 umfasst vorliegend zusätzlich eine aktive Bedienoberfläche 26. Diese ist im vorliegenden Beispiel ausgebildet, optische Informationen über die mit dem mechanisch schaltbaren Bedienbereich 20 betätigbare Funktion bereitzustellen.

Dabei handelt es sich vorliegend um ein hinterleuchtbares Symbol für ein Warnblinklicht. In anderen Ausführungsformen kann die aktive Bedienoberfläche 26 aber auch weitere Funktionen umfassen und dabei beispielsweise selbst nach Art eines Touchdisplays ausgebildet sein.

Figur 2 zeigt das erfindungsgemäße Fahrzeug 14, vorliegend ausgebildet als Kraftfahrzug 28. Die Bedienfeldanordnung 10 ist dabei in die Mittelkonsole 12 integriert.

### Bezugszeichenliste

- 10: Bedienfeldanordnung
- 12: Mittelkonsole
- 14: Fahrzeug
- 16: berührungssensitiver Bedienbereich
- 18: Bedienelement
- 20: mechanisch schaltbarer Bedienbereich
- 22: Bedienoberfläche
- 24: Fuge
- 26: aktive Bedienoberfläche
- 28: Kraftfahrzug

## Patentansprüche

1. Bedienfeldanordnung (10) für ein Fahrzeug (14), umfassend:
- einen berührungssensitiven Bedienbereich (16);
- einen mechanisch schaltbaren Bedienbereich (20), der in den berührungssensitiven Bedienbereich (16) integriert ist; und
- eine Steuerung,
wobei der mechanisch schaltbare Bedienbereich (20) in den berührungssensitiven Bedienbereich (16) eingefasst ist und eine Bedienoberfläche (22) der Bedienfeldanordnung (10) abschnittsweise durch den mechanisch schaltbaren Bedienbereich (20) und abschnittsweise durch den berührungssensitiven Bedienbereich (16) gebildet wird,
**dadurch gekennzeichnet, dass**
der mechanisch schaltbare Bedienbereich (20) zusätzlich eine aktive Bedienoberfläche (26) umfasst, wobei
die Steuerung ausgebildet ist, eine Bedienfunktion der aktiven Bedienoberfläche (26) zu sperren, bis durch eine Betätigung des mechanisch schaltbaren Bedienbereichs (20) ein definiertes mechanisches Signal erzeugt wird.

2. Bedienfeldanordnung (10) nach Anspruch 1, **dadurch gekennzeichnet, dass** die aktive Bedienoberfläche (26) berührungssensitive Funktionalitäten umfasst.

3. Bedienfeldanordnung (10) nach Anspruch 1 oder 2, **dadurch gekennzeichnet, dass** der mechanisch schaltbare Bedienbereich (20) ein fahrzeugsicherheitsrelevantes Bedienelement bildet, insbesondere ein Warnblinkbedienelement.

4. Fahrzeug (14), umfassend eine Bedienfeldanordnung (10) nach einem der vorhergehenden Ansprüche.

## Claims

1. Control panel arrangement (10) for a vehicle (14), comprising:
- a touch-sensitive operating region (16);
- a mechanically switchable operating region (20) integrated into the touch-sensitive operating region (16); and
- a controller,
the mechanically switchable operating region (20) being enclosed in the touch-sensitive operating region (16) and an operating surface (22) of the control panel arrangement (10) being formed in part by the mechanically switchable operating region (20) and in part by the touch-sensitive operating region (16),
**characterized in that**
the mechanically switchable operating region (20) additionally comprises an active operating surface (26), the controller being designed to lock an operating function of the active operating surface (26) until a defined mechanical signal is generated by an actuation of the mechanically switchable operating region (20).

2. Control panel arrangement (10) according to claim 1,
**characterized in that** the active operating surface (26) comprises touch-sensitive functionalities.

3. Control panel arrangement (10) according to claim 1 or 2,
**characterized in that** the mechanically switchable operating region (20) forms an operating element that is relevant to vehicle safety, in particular a hazard light operating element.

4. Vehicle (14) comprising a control panel arrangement (10) according to any of the preceding claims.

## Revendications

1. Agencement formant panneau de manipulation (10) pour un véhicule (14), comprenant :
- une zone de manipulation sensible au toucher (16) ;
- une zone de manipulation commutable mécaniquement (20) qui est intégrée dans la zone de manipulation sensible au toucher (16) ; et
- une commande, dans lequel la zone de manipulation commutable mécaniquement (20) est insérée dans la zone de manipulation sensible au toucher (16) et une surface de manipulation (22) de l'agencement formant panneau de manipulation (10) est formée dans certaines sections par la zone de manipulation commutable mécaniquement (20) et dans certaines sections par la zone de manipulation sensible au toucher (16), **caractérisé en ce que** la zone de manipulation commutable mécaniquement (20) comprend en outre une surface de manipulation active (26), dans lequel la commande est configurée pour bloquer une fonction de manipulation de la surface de manipulation active (26) jusqu'à ce qu'un signal mécanique défini soit généré par un actionnement de la zone de manipulation commutable mécaniquement (20).

2. Agencement formant panneau de manipulation (10) selon la revendication 1, **caractérisé en ce que** la surface de manipulation active (26) comprend des fonctionnalités sensibles au toucher.

3. Agencement formant panneau de manipulation (10) selon la revendication 1 ou 2, **caractérisé en ce que** la zone de manipulation commutable mécaniquement (20) forme un élément de manipulation important pour la sécurité du véhicule, en particulier un élément de manipulation des feux de détresse.

4. Véhicule (14), comprenant un agencement formant panneau de manipulation (10) selon l'une des revendications précédentes.
